Europäisches Patentamt

European Patent Office

Office européen des brevets

(11) Numéro de publication: **0 196 252**
**A1**

## (12) DEMANDE DE BREVET EUROPEEN

(21) Numéro de dépôt: **86400513.7**

(22) Date de dépôt: **11.03.86**

(51) Int. Cl.⁴: **H01J 37/20**

(30) Priorité: **15.03.85 FR 8503881**

(43) Date de publication de la demande:
**01.10.86 Bulletin 86/40**

(84) Etats contractants désignés:
**CH DE GB LI**

(71) Demandeur: **COMMISSARIAT A L'ENERGIE ATOMIQUE Etablissement de Caractère Scientifique Technique et Industriel 31/33, rue de la Fédération F-75015 Paris(FR)**

(72) Inventeur: **Juret, Christian 30, Avenue de la République F-91360 Villemoisson sur Orge(FR)**
Inventeur: **Loued, Salem 29, rue de la Division Leclerc F-91300 Massy(FR)**
Inventeur: **Rapineau, Luc 62, rue Voltaire La Chevauchée F-91160 Longjumeau(FR)**

(74) Mandataire: **Mongrédien, André et al c/o BREVATOME 25, rue de Ponthieu F-75008 Paris(FR)**

(54) **Boîte de transport.**

(57) Boîte pour le transport d'un échantillon d'une première à une seconde enceinte étanche.

Elle comporte :

-un corps étanche (2) délimitant une chambre (4) comportant une ouverture (5), une bride (6) pour raccorder le corps (2) à ladite seconde enceite étanche ;

-une clapet (16) apte à obturer de manière étanche l'ouverture (5) de la chambre (4) ;

-des moyens (28, 30) pour commander l'ouverture et la fermeture de clapet (16) ;

-des moyens pour fixer un plateau porte-échantillon (38) sur une paroi (44) de la chambre (4).

FIG. 2

# BOITE DE TRANSPORT

L'invention concerne une boîte qui permet le transport d'un échantillon d'une enceinte étanche une autre enceinte étanche.

Connaître les propriétés physico-chimiques de la surface d'un matériau est une préoccupation importante dans les milieux scientifiques et industriels. Ainsi, au cours de ces dernières années se sont développés des systèmes d'analyse pour l'étude des surfaces au niveau atomique. Généralement, ces systèmes reposent sur une infrastructure mécanique complexe basée sur la technique de l'ultravide. La complexité de l'interprétation des résultats impose l'utilisation de plusieurs dispositifs de diagnostic implantés soit dans une même installation qui de ce fait devient difficile à exploiter, soit sur des installations spécialisées distinctes.

Par exemple, il est intéressant d'étudier le greffage des molécules de polymères polyacrylonitriles (PAN) à la surface de métaux ou les interactions monocristaux-gaz, et les propriétés de l'échantillon qui en résulte. Cette étude est faite grâce à un système expérimental qui utilise la spectroscopie d'électrons lents créés par désexcitation d'atomes métastables (MDS) et photoémission dans l'ultraviolet - (UPS). Ce système met en oeuvre un faisceau d'atomes d'hélium métastables pompés différentiellement qui débouche dans une enceinte ultra-vide (10⁻⁸ Pa) dans laquelle sont placés l'échantillon à étudier et un analyseur électrostatique à potentiel retardateur recueillant les informations dues à la collision des atomes métastables et des photons avec la surface d'un échantillon. Cet échantillon doit être préparé dans une boîte à gants, sous une atmosphère de gaz neutre. Pour que l'étude de la surface de l'échantillon puisse être faite dans de bonnes conditions, il faut que l'échantillon ne soit pas exposé à l'action de l'atmosphère.

L'invention a pour objet une boîte de transport qui permet d'atteindre les objectifs ci-dessus. Elle s'applique particulièrement au transfert d'un échantillon préparé en boîte à gants sous une atmosphère neutre. Après préparation, l'échantillon est transféré dans une enceinte à ultra-vide dans laquelle ses propriétés physico-chimiques seront étudiées.

Pour cela, le taux de fuite de la boîte doit être suffisamment faible pour qu'il soit possible de conserver une légère surpression du gaz qui constituait l'atmosphère originelle de la boîte à gants ou bien de maintenir un vide d'au moins 10⁻⁴ Pa lors du transfert de l'échantillon entre la boîte à gants et l'enceinte ultra-vide.

L'introduction de l'échantillon doit s'effectuer sans que le volume intérieur de l'enceinte ultra-vide soit mis en communication avec l'atmosphère.

Le volume interne de la boîte de transport doit être suffisamment grand pour pouvoir accueillir un porte-échantillon de dimensions courantes avec son échantillon.

Précisément, l'invention concerne une boîte pour le transport d'échantillons conservés sous atmosphères contrôlée d'une première enceinte étanche à une seconde enceinte étanche, caractérisée par :

-un corps étanche délimitant une chambre comportant une bride de raccordement avec une ouverture qui est l'ouverture de la chambre et pouvant s'appliquer contre une bride de raccordement de même type de ladite seconde enceinte ;

-un clapet apte à obturer de manière étanche l'ouverture de la chambre ;

-des moyens pour commander l'ouverture et la fermeture du clapet ;

-des moyens pour fixer un plateau porte-échantillon sur une paroi de la chambre ;

-des moyens pour immobiliser le plateau porte-échantillon lors du transport de la boîte.

De préférence, le clapet est monté pivotant sur le corps, un joint d'étanchéité étant logé dans une gorge prévue dans le corps autour de l'ouverture.

De préférence un tirant est articulé au centre du clapet à l'une de ses extrémités et relié à son autre extrémité à une vis micrométrique faisant partie d'un système vis-écrou.

De préférence, les moyens pour fixer le plateau porte-échantillon sont constitués par deux trous espacés axialement, prévus dans une paroi de la chambre et par deux ergots prévus sur le plateau porte-échantillon, les ergots étant aptes à venir se loger dans les deux trous.

Les moyens pour immobiliser le plateau porte-échantillon lors du transport de la boîte sont constitués par la bielle articulée au centre du clapet sur laquelle le porte-échantillon s'appuie, la boîte de transport étant fermée.

D'autres caractéristiques et avantages de l'invention apparaîtront encore à la lecture de la description qui suit d'un exemple de réalisation donné à titre indicatif, en référence aux figures annexées, sur lesquelles :

-la figure 1 est une vue en plan, schématique, d'un sytème expérimental qui peut être utilisé par exemple pour l'examen de la surface d'un échantillon par spectroscopie d'électrons lents,

-la figure 2 est une vue en coupe, selon la ligne II-II de la figure 1, d'une boîte de transport conforme à l'invention raccordée à une bride d'une enceinte étanche constituée par une croix de transfert,

-la figure 3 est une vue en perspective d'un plateau porte-échantillon, d'un porte échantillon et de l'échantillon destiné à la boîte de transport de la figure 2,

-la figure 4 montre l'attache du clapet sur le corps de la boîte,

-les figures 5 à 8 représentent quatre positions différentes du clapet de fermeture,

-la figure 9 est une vue schématique en plan d'un système expérimental identique à celui de la figure 1, mais dans lequel la croix de transfert est raccordée à l'enceinte par l'intermédiaire d'une chambre de préparation et d'introduction,

- la figure 10 représente une variante de la boîte de transport comportant un ascenseur permettant de loger plusieurs plateaux porte-échantillon,

-la figure 11 est une vue en coupe de la variante représentée sur la figure 10.

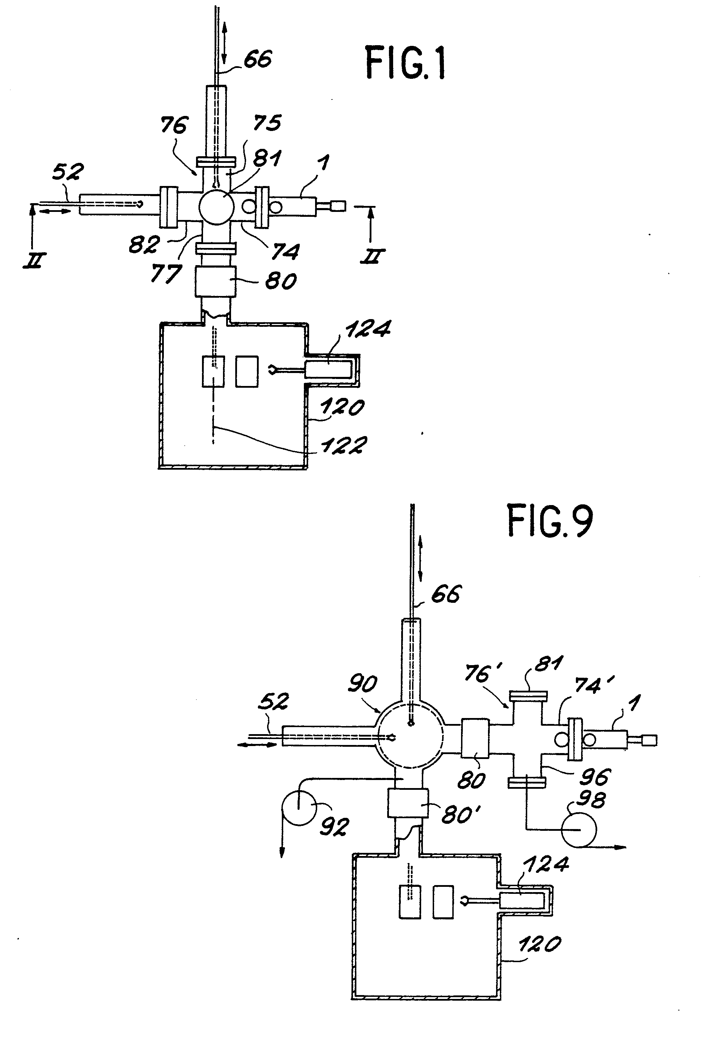

On a représenté sur la figure 1 un système expérimental qui peut utiliser par exemple la spectroscopie d'électrons lents pour l'étude physicochimique des propriétés de la surface d'un échantillon. Ce système se compose d'une enceinte expérimentale 120 traversée par un faisceau d'atomes d'hélium métastables, qui vient frapper un échantillon situé dans le plan d'étude 122. Cet échantillon est porté par un porte-échantillon et fixé à l'extrémité du bras d'un manipulateur 124. Ce manipulateur est un dispositif étanche fixé à l'enceinte 120 et permettant de déplacer l'échantillon selon trois axes X, Y, Z orthogonaux. Il est utilisé sous ultra-vide pour positionner d'une manière extrêmement précise un ou plusieurs échantillons devant un appareil ultra-vide. De tels manipulateurs sont connus dans l'état de la technique. A titre d'exemple, les manipulateurs fabriqués par la Société Riber conviennent à une telle application.

Des pompes secondaires et une cryo-pompe sont utilisées pour obtenir un vide inférieur $10^{-7}$ Pa dans l'enceinte 120. Etant donné que ces pompes ne font pas partie de l'invention, elles n'ont pas été représentées sur la figure 1.

Lorsque l'on étudie la surface de certains échantillons, par exemple des échantillons recouverts d'une monocouche, éventuellement incomplète, d'acrylonitrile ou d'une très fine couche de PAN, il est nécessaire que les échantillons ne soient pas exposés à l'atmosphère car le dépôt de ces monocouches est réalisé par voie électrochimique sur une surface métallique, dans une boîte à gants, sous une atmosphère d'argon contenant des quantités d'oxygène inférieures à 5 ppm, des quantités d'eau inférieures à 5 ppm et des quantités d'azote inférieures à 40 ppm. Le transfert de l'échantillon entre la boîte à gants (non représentée), dans laquelle il est préparé, et le système expérimental 120 doit donc être effectué au moyen d'une boîte de transfert qui le protège de l'atmosphère extérieure.

Comme on le constate sur la figure 1, la boîte de transport de l'invention est raccordée à une croix 76. Dans le système représenté sur la figure 1, la croix comprend six branches de section circulaire, qui peuvent avoir le même diamètre interne ou des diamètres différents. Quatre de ces branches sont représentées dans le plan de la figure 1 (rèf 74, 78, 79, 82). Deux autres branches 75 et 77 s'étendent selon une direction perpendiculaire au plan de la figure 1, c'est-à-dire horizontalement. Le diamètre de la branche 79 doit être tel qu'il permette l'ouverture du clapet 16.

La branche horizontale 77 est raccordée au dispositif expérimental 120 par l'intermédiaire d'une vanne tiroir d'isolement 80'. Cette vanne sert l'isolation de l'enceinte expérimentale 120 par rapport à la boîte de transfert 1 et à la croix 76 et évite une entrée d'air et une pollution des échantillons stockés dans l'enceinte expérimentale 120 lors de l'introduction. La branche horizontale 75 est munie d'une canne de transfert 66.

La branche horizontale 82 comporte une canne de transfert 52. Un hublot de visualisation 81 qui facilite les manipulations est raccordé à la branche 78.

La branche inférieure 79 est raccordée à un système de pompage (non représenté) qui permet de faire le vide à l'intérieur de la croix 76. La croix permet de transférer un échantillon par l'intermédiaire des cannes et aussi d'assurer un vide convenable compatible avec celui de la chambre expérimentale 120. Le temps de vie des pompes d'ultra-vide grâce à cette atmosphère-tampon s'en trouve prolongé.

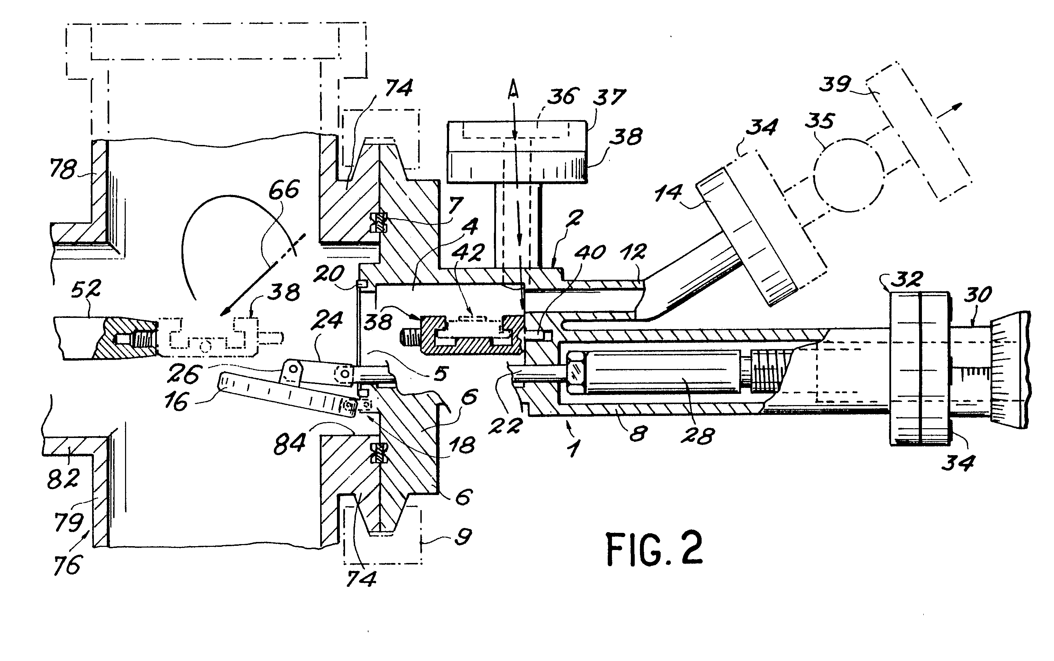

On a représenté sur la figure 2 une boîte de transport conforme à l'invention. Elle permet le transfert d'un échantillon entre une enceinte étanche telle qu'une boîte à gants dans laquelle le dépôt d'une monocouche d'acrylonitrile ou de PAN est réalisé, et une enceinte expérimentale 120 du type de celle qui est représentée sur la figure 1, sans que cet échantillon soit exposé à l'atmosphère.

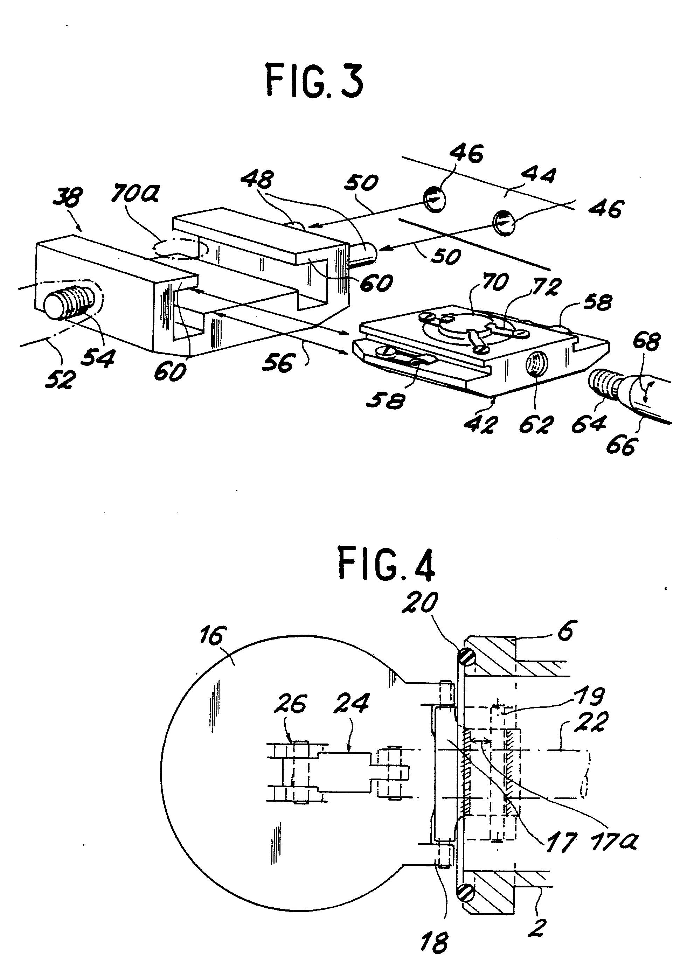

Cette boîte de transport 1 peut accueillir un porte-échantillon de dimensions courantes et elle est suffisamment petite pour passer au travers du sas d'une boîte à gants. Elle comporte un corps 2 qui délimite une chambre intérieure 4. Dans l'exemple représenté, la chambre possède une longueur de 34 mm et un diamètre intérieur de 24 mm. Une bride 6 est raccordée au corps 4. Du côté du corps opposé à la bride 6, on trouve un tube 8 terminé par une bride et une canalisation 12 qui débouche à la partie supérieure de la chambre et qui est terminée par une bride 14. La chambre 4 est fermée par un clapet 16 articulé par l'intermédiaire d'une pièce de liaison 18. Une extrémité de cette pièce de liaison est goupillée entre les deux pattes 17 du clapet 16 d'une part (figure 4), et sur le rebord de l'extrémité du corps 2 d'autre part. A cette dernière extrémité, la pièce de liaison 18 présente une lumière qui permet l'articulation du clapet et son ouverture de 90° à 200° environ par rapport à l'axe longitudinal de la chambre 4. Un joint étanche en Viton 20 est logé dans une gorge usinée à l'extrémité du corps 2.

L'ouverture et la fermeture du clapet 16 sont assurées par un tirant 22. A une première extrémité, ce tirant est articulé à une bielle 24 elle-même fixée sur une patte 26 articulée au centre du clapet 16. A son autre extrémité, le tirant 22 est fixé à une vis 28 déplaçable en translation par l'intermédiaire d'un système vis-écrou. Le déplacement du tirant 22 est contrôlé par une vis micrométrique d'une course maximale de 25 millimètres. Cette vis micrométrique est munie de graduations qui permettent de connaître avec précision la position ouverte ou fermée du clapet. En prenant des repères, on peut donc manoeuvrer le clapet avec sûreté, car celui-ci n'est pas visible de l'extérieur lorsque la boîte de transport de l'invention est raccordée sur l'enceinte étanche constituée d'une croix, comme c'est le cas sur la figure 2.

Lorsque le clapet est en position fermée, la bielle 24 vient bloquer le plateau porte-échantillon 38 et assure ainsi son immobilisation.

On a représenté sur la figure 4 l'attache du clapet 16 sur le corps de la boîte. Cette attache se compose de deux pattes 18 solidaires du clapet 16, d'une pièce de liaison 17 articulée sur les pattes 18 à une de ses extrémités. La pièce de liaison 17 comporte une lumière 17a. Un axe 19 solidaire du corps 6 traverse la lumière 17a.

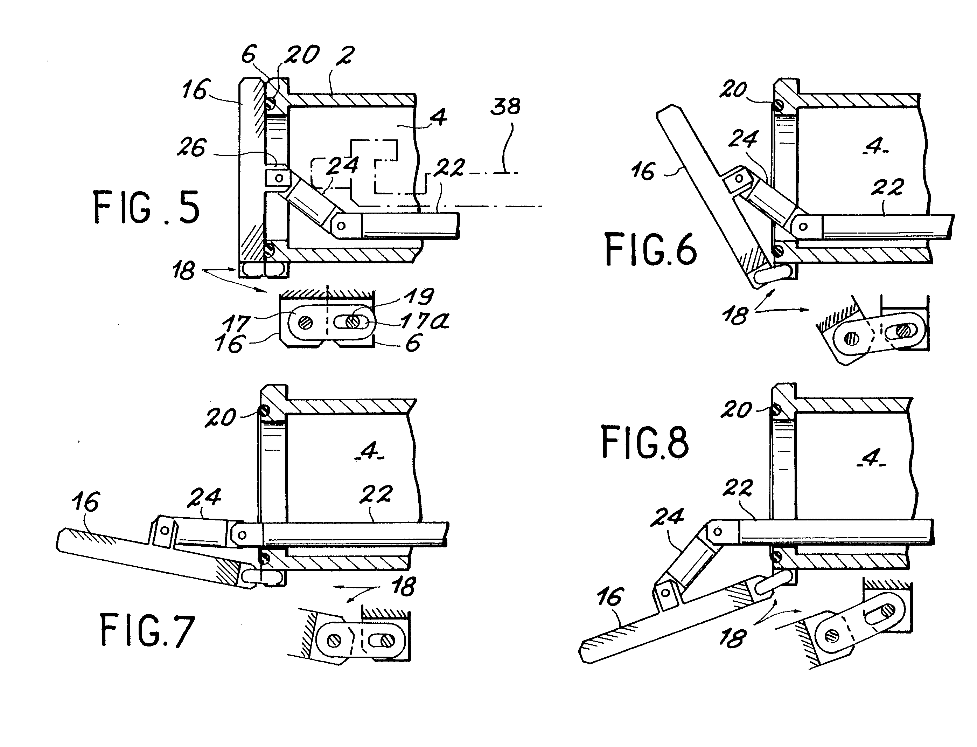

On a représenté sur les figures 5 à 8 quatre positions différentes du clapet de fermeture. Sur la figure 5, ce clapet est en position fermée. Sur la figure 6, il est en début d'ouverture. Sur la figure 7 il est en position fonctionnelle, c'est-à-dire que le clapet est dans une position sensiblement horizontale qui dégage totalement l'entrée de la chambre pour l'introduction et la sortie du plateau porte-échantillon. Enfin, sur la figure 8, le clapet est en position d'ouverture maximale. Dans cette position, il fait un angle de 200° environ par rapport à l'axe de la chambre 4. Le dispositif 30 de commande à vis micrométrique est raccordé au tube 8 par une bride 32 fixée au moyen de vis 34.

La canalisation 12 (figure 2) est destinée à introduire un gaz, par exemple un gaz neutre tel que l'argon, dans la chambre 4, ou encore à entretenir un vide dans cette chambre dans le cas où la durée du transfert serait longue et où, par suite du dégazage des parois de la chambre de la boîte de transfert. La canalisation 12 présente une bride 14 sur laquelle s'appuie la bride 34 ; une vanne étanche 35 ferme la canalisation 12 ; une bride 39 sert au raccordement à une pompe ou à une introduction de gaz.

Sur le corps 2, on trouve encore un hublot 36 monté sur une bride 37 fixée sur une bride 38 perpendiculairement à l'axe longitudinal A de la chambre 4. Le hublot 36 permet d'observer l'intérieur de la chambre et particulièrement la partie arrière de cette chambre dans laquelle le plateau de support du porte-échantillon 38 est fixé par l'intermédiaire de deux ergots de fixation 40 dans des orifices espacés.

La bride 6 est une bride du type de celles qui présentent des profils de portée de joint compatibles avec ceux de la bride de l'enceinte étanche. On peut choisir des brides du type à couteaux; un joint métallique 7 est serré entre les deux brides. Plus précisément, ce sont les couteaux de chacune des brides des qui pénètrent dans le joint 7 en le déformant de manière à assurer une très grande étanchéité. Ce type de joint est utilisé lorsque l'on désire obtenir une étanchéité très efficace, en particulier un vide très poussé. Cependant, il va de soi qu'un autre type de bride et de joint pourrait être utilisé dans le cadre de la présente invention.

On a représenté sur la figure 3 une vue en perspective d'un plateau 38 de support d'un porte-échantillon déjà mentionné en référence à la figure 2 et d'un porte-échantillon 42 représenté sorti du plateau de porte-échantillon 38. On a également représenté - schématiquement en perspective une partie de la paroi arrière 44 de la chambre 4 (c'est-à-dire, en d'autres termes, la paroi opposée à l'ouverture de la chambre). Dans cette paroi sont formés deux trous espacés et d'axe parallèle à l'axe longitudinal de la chambre 46. Deux ergots 48 sont prévus sur le plateau 38. Leur espacement correspond à celui des trous 46. Grâce à ces ergots, le plateau peut être introduit et maintenu de manière stable dans la paroi 44. Son maintien est assuré, de plus, par la biellette 24 qui arrêtera la course du plateau si celui-ci se déplace lors du transport de la boîte de transfert d'installation en installation . L'introduction et le retrait du plateau porte-échantillon, selon les flèches 50, sont obtenus au moyen d'une canne de transfert 52 représentée en traits mixtes. Le plateau 38 comporte un embout fileté 54 situé à l'extrémité du plateau opposée aux ergots 48. La canne 52 comporte un trou taraudé correspondant. Cette canne 52 vient se visser sur l'embout fileté, le plateau 38 étant immobilisé par les deux ergots 48 espacés l'un de l'autre. Lorsque la canne 52 mobile en rotation et en translation est vissée sur l'embout fileté 54, on peut retirer le plateau hors de la chambre ou au contraire l'introduire dans cette chambre et le fixer dans la paroi 44. Le hublot de visualisation 36 mentionné précédemment permet de contrôler visuellement la bonne position des pieds 48 par rapport aux trous 46.

Le plateau 38 est destiné à recevoir un porte-échantillon 42. Dans l'exemple de réalisation décrit, le porte-échantillon est un porte-échantillon du commerce fabriqué par la Société Riber, mais il va de soi qu'un autre type de porte-échantillon convenable peut être utilisé. Le porte-échantillon 42 est introduit sur le plateau 38 et extrait de ce plateau perpendiculairement à l'axe longitudinal du plateau 38 qui est également l'axe longitudinal de la chambre. On a schématisé cette introduction et cette extraction par les flèches 56. Le porte-échantillon 42 comporte deux ressorts 58 qui viennent s'engager sous les ailes 60 du plateau 38. Les ressorts 58 créent des forces de frottement qui maintiennent le porte-échantillon dans le plateau.

Le porte-échantillon 42 comporte en outre un trou taraudé 62 qui est destiné à coopérer avec un embout fileté 64 d'une canne 66. La canne 66 est mobile en rotation et en translation comme schématisé par la flèche 68. Elle peut être vissée dans le trou taraudé 62 puis déplacée en translation soit pour introduire le porte-échantillon 42 dans le plateau 38 ou pour l'en extraire.

Le porte-échantillon 42 supporte un échantillon 70 qui peut être maintenu par des pattes de fixation telles que 72. On a représenté par un cercle en traits mixtes la position 70a de l'échantillon 70 lorsque le porte échantillon 42 est introduit dans le plateau 38.

Le fonctionnement de la boîte de transfert d'échantillons est le suivant.

Tout d'abord, la boîte de transfert est introduite dans la boîte à gants dans laquelle se fait la préparation de l'échantillon. Cette introduction est effectuée par le sas de la boîte à gants. On sait en effet qu'une boîte à gants comporte généralement un sas qui permet l'introduction et l'évacuation d'objet sans rupture de son étanchéité. La boîte de transfert introduite doit présenter des dimensions suffisamment petites pour pouvoir tenir dans un sas de boîte à gants. Elle peut donc être introduite dans une boîte à gants et extraite de cette boîte à gants sans difficultés particulières.

La boîte de transfert ayant été introduite à l'intérieur de la boîte à gants, on ouvre le clapet 16 au moyen du dispositif de commande 30 à vis micrométrique qui est actionné par un opérateur depuis l'extérieur de la boîte à gants au moyen des gants de la boîte.

Une fois préparé, l'échantillon est placé sur le porte-échantillon 42. Le porte-échantillon est glissé dans le plateau 38. Ce plateau est lui-même inséré, par l'intermédiaire des ergots de fixation 40, dans les trous 46. Toutes ces opérations sont effectuées manuellement par l'intermédiaire du système de gants. Le clapet 16 est alors fermé en manoeuvrant le dispositif de commande à vis micrométrique 30. A ce stade, l'échantillon 70 est enfermé dans la boîte sous une atmosphère d'un gaz neutre tel que l'argon, par exemple, si la boîte à gants contient un tel gaz. Généralement, l'atmosphère interne de la boîte à gants est en légère surpression par rapport à l'atmosphère. L'étanchéité assurée par le joint 20 est telle qu'il est possible de conserver cette légère surpression pendant le transfert de l'échantillon.

La boîte de transfert est alors extraite de la boîte à gants en passant par le sas de cette dernière. Si l'on désire établir par exemple le vide dans la chambre 4, on connecte la bride 37 à une canalisation raccordée à une pompe à vide afin d'établir un vide d'au moins $10^{-4}$ Pa dans la chambre 4. Le transfert peut alors être effectué. L'échantillon peut être transporté jusqu'à une installation, éventuellement située dans un autre bâtiment. Il peut également être stocké quelques heures si on n'en a pas besoin immédiatement. Dans le cas où la durée du transfert est longue, le vide qui règne à l'intérieur de la chambre, si tel est le cas, peut être refait. De la même manière, si l'atmosphère interne de la chambre est en légère surpression, on peut rajouter une quantité de gaz pour compenser les fuites.

La boîte de transfert est ensuite raccordée à la croix 76 par l'intermédiaire de la bride 74. La croix a pour fonction de permettre l'acheminement de l'échantillon jusqu'à l'enceinte expérimentale (voir figure 1).

Le fait que le diamètre des branches verticales soit relativement important permet l'escamotage du clapet 16 lors de son ouverture complète (position représentée en figure 7). En effet, bien que le pourtour du clapet soit circulaire de manière à pouvoir pénétrer et s'escamoter dans une canalisation de diamètre supérieur ou égal à 35 mm, la manoeuvre est plus aisée si l'on dispose de davantage de place.

Sur la figure 2, on a représenté schématiquement seulement l'extrémité de cette canne qui est munie d'un embout fileté. Cette canne peut être déplacée en translation.

La canne auxiliaire 52 comporte un trou taraudé destiné à coopérer avec l'embout fileté 54 du plateau 38. La canne 52 possède une course inférieure à celle de la canne 66. Elle peut présenter un système de centrage articulé sur rotule qui facilite le positionnement du trou taraudé sur l'embout fileté du plateau 38 lors de l'extraction de ce plateau hors de la chambre 4. Le système de centrage facilite également la remise en place du plateau dans la chambre 4, c'est-à-dire, en d'autres termes, l'insertion des ergots 48 dans les trous 46, comme on le décrira ultérieurement. Un soufflet assure l'étanchéité du système d'articulation sur rotule de la petite canne 52.

La bride 6 de la boîte de transfert étant fixée par exemple au moyen de vis ou de colliers 9, schématisées par des traits mixtes, sur la bride de la branche 84 de la croix 76, comme représenté sur la figure 2, après pompage dans la croix on ouvre le clampet 16 au moyen du dispositif de commande 30 à vis micrométrique. On peut observer la position ouverte ou fermée du clapet à l'aide du hublot de visualisation 81 mais même en l'absence de visibilité, les repères précis de la vis micrométrique permettent de connaître la position ouverte ou fermée du clapet. Lorsque le clapet est dans sa position ouverte représentée sur la figure 2, et également sur la figure 6, la canne de transfert auxiliaire 52 est vissée sur l'embout fileté 54 du plateau 38. Puis la canne 52 est déplacée en translation vers la gauche sur la figure 2 de manière à amener le plateau 38 de la position représentée en traits pleins à la position représentée en traits mixtes située à l'intersection des branches de la croix 76. Une vis micrométrique (non représentée) peut permettre de commander avec plus de précision la position de la petite canne de transfert et de l'amener exactement à l'emplacement voulu. Dans cette position, on vient chercher le porte-échantillon 42 à l'aide de la canne de transfert principale 66. Le porte-échantillon 42 est alors prêt à être transféré dans l'enceinte expérimentale.

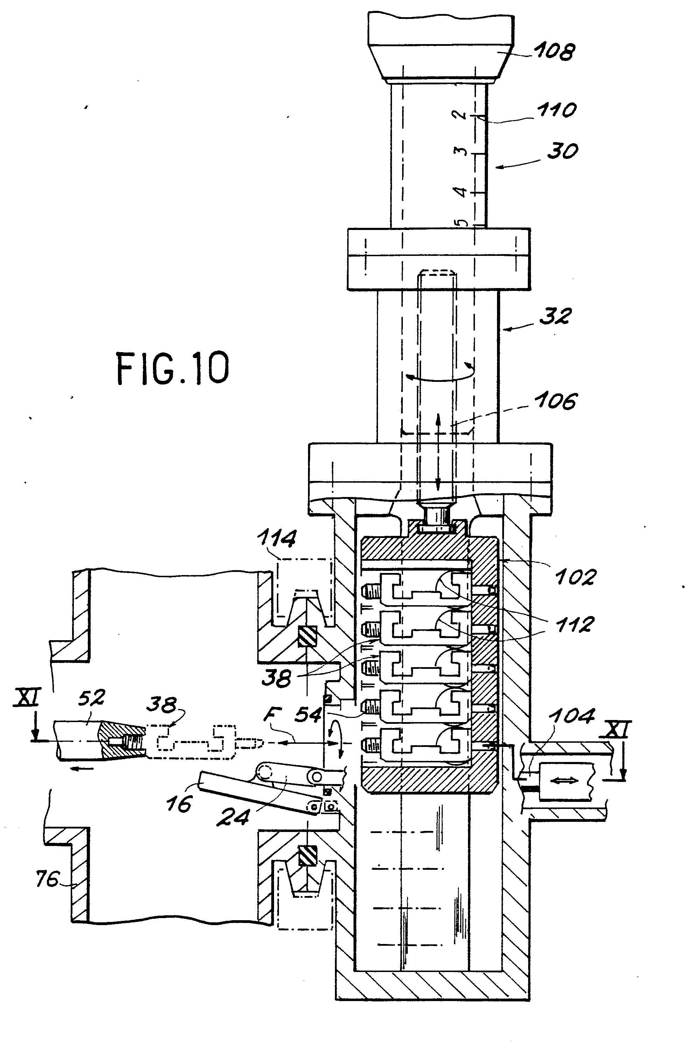

On a représenté sur la figure 9, la boîte de transfert pour échantillon 1, accolée par l'intermédiaire d'une croix 76' à une chambre de préparation et d'introduction désignée par la référence générale 90. Dans l'exemple représenté, cette chambre est du type SPC 200 commercialisée par la Société RIBER. Une vanne tiroir d'isolement 80 est interposée entre la chambre 90 et la croix 76.

La chambre d'introduction 90 est raccordée à l'enceinte expérimentale 120 par l'intermédiaire d'une vanne ultra-vide 80' utilisant une bride à couteaux. Un groupe de pompage turbomoléculaire 92 qui permet d'obtenir ùn vide allant jusqu'à $10^{-5}$ Pa est raccordé à la chambre 90. La chambre est équipée d'une canne de transfert 66, d'un ascenseur de stockage prévu pour plusieurs échantillons montés chacun sur un porte-échantillon. Les porte-échantillons sont introduits dans la chambre 90 et stockés dans l'ascenseur.

De plus, de manière identique au mode de réalisation représenté sur la figure 2, une canne de transfert 52 est montée sur la chambre 90. Elle est munie d'un système comportant un soufflet articulé sur rotule qui facilite l'accrochage et la remise en place du plateau 38. Cette canne est équipée à son extrémité d'un trou taraudé qui se visse sur l'embout fileté 54 du plateau 38.

Sur la bride 96 de la croix 76' est raccordée une canalisation reliée à un groupe de pompage turbomoléculaire 98.

Dans la chambre 90, un hublot 95 de grandes dimensions placé dans un plan perpendiculaire permet de venir chercher plus facilement le porte-échantillons 42 sur lê plateau 38 au moyen de la canne principale 66.

Le fonctionnement de ce mode de réalisation est le suivant. La boîte de transfert 1 est introduite vide dans une boîte à gants ou une enceinte dans laquelle l'échantillon a été préparé. On fixe l'échantillon 70 sur le porte-échantillon 42 au moyen des gants de la boîte. Puis le porte-échantillon est glissé dans le plateau 38, toujours au moyen des gants de la boîte à gants. Ce plateau est inséré manuellement dans la boîte de transfert et immobilisé par les ergots 40. On ferme alors le clapet 16 en manoeuvrant la traversée mouvements de translation 28, 30 et on sort la boîte de transfert par le sas de la boîte à gants.

Etant donné que le clapet est étanche, l'échantillon ne risque pas d'être pollué lors du transfert et de la mise en place de la boîte sur la croix 76' montée sur la chambre 90. Une fois la bride 74' convenablement serrée et la chambre d'introduction 90 isolée de son groupe de pompage 92, on utilise le groupe de pompage turbomoléculaire 98 relié à la bride 96 de la croix 76 pour faire le vide dans la croix 76. On fait ensuite le vide dans la boîte de transfert en ouvrant le clapet 16.

Lorsque la pression dans la chambre 90 est identique à la pression qui règne à l'intérieur de la chambre 4 de la boîte de transfert 1, on peut ouvrir la vanne tiroir d'isolement 80 et, en se servant de la canne de transfert 52, venir chercher le plateau 38 dans la chambre 4 et l'introduire au centre de la chambre 90, sur la trajectoire de la canne de transfert 66. Avec cette canne 66, ˙on vient chercher le porte-échantillon 42 et on le stocke dans l'ascenseur. Si on désire examiner l'un des échantillons stockés, on fait le vide dans la chambre 90, on vient chercher le porte-échantillon 42 dans l'ascenseur avec la canne 66, puis on transfère l'échantillon sur le manipulateur 124 de l'enceinte expérimentale 120 en ouvrant une vanne entre la chambre et cette enceinte. On retire la canne 66 et, une fois fermée la vanne qui relie la chambre 90 à l'enceinte 120, l'échantillon est prêt à être étudié.

Il est à remarquer que l'opération de transfert inverse peut être réalisée. En d'autres termes, on peut replacer un échantillon dans la boîte de transfert sans que celui-ci soit exposé à être pollué par l'atmosphère. De cette manière, on est certain que la surface de l'échantillon n'a pas été dégradée au cours des manipulations successives et que l'échantillon peut subir d'autres traitements ou examens dans d'autres enceintes.

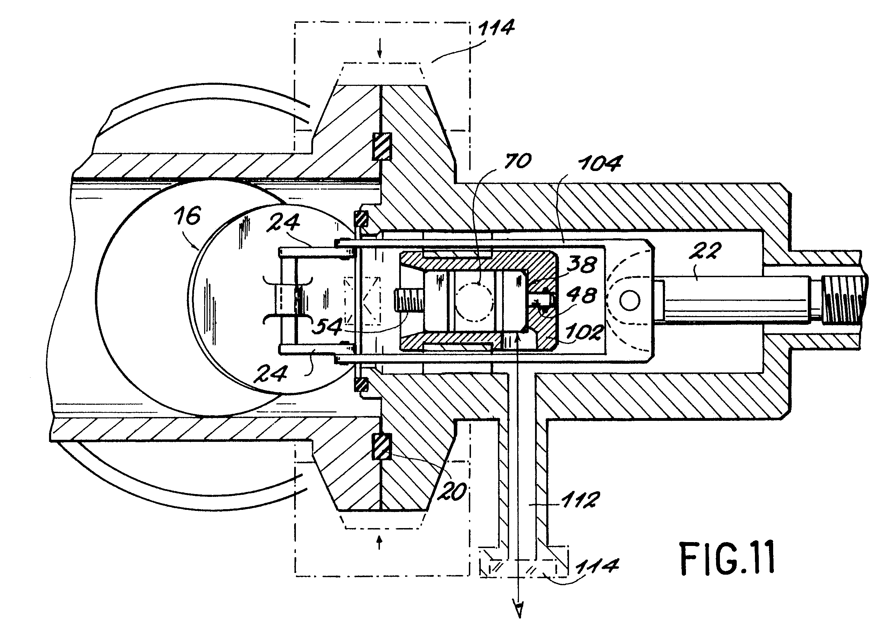

On a représenté sur les figures 10 et 11 une variante de réalisation de la boîte de transfert de l'invention. Elle comporte un ascenseur 102 qui permet de loger plusieurs plateaux porte-échantillon 38, cinq dans l'exemple de réalisation représenté. Comme pour le mode de réalisation décrit précédemment, chaque plateau porte-échantillon 38 comporte deux pieds 48 qui viennent s'engager dans des trous 46 correspondants pratiqués dans la paroi arrière de l'ascenseur 102. L'ascenseur peut être déplacé selon une direction horizontale comme schématisé par la flèche 106 au moyen d'un système vis-écrou. Un positionnement précis de l'ascenseur peut être obtenu grâce à une vis micrométrique 108 de telle manière que l'embout fileté 54 d'un plateau porte-échantillon donné se trouve en regard de l'axe de la came 52 afin de pouvoir être introduit dans l'ascenseur 102 et en être extrait de la même manière - (flèche F). Etant donné que l'ascenseur 102 renferme cinq plateaux porte-échantillon, on a prévu cinq graduations numérotées de 1 à 5, seules les graduations 2 à 5 étant visibles sur la figure 10. Une pluralité de trous d'observation 112 permet en outre d'observer visuellement l'introduction des pieds 48 dans les trous 46.

La fixation de la boîte de transfert sur la croix 76 est assurée au moyen d'un collier 114 représenté en traits mixtes, qui vient enserrer une surface conique de la bride de la croix 76 et une surface conique correspondante de la bride de la boîte de transfert. Naturellement, un joint d'étanchéité est prévu entre ces deux brides.

La figure 11, qui est une vue en coupe selon la ligne II-II de la figure 10, permet d'apprécier en particulier la forme circulaire du clapet 16, et les trous d'observation 112, fermés chacun par un hublot 114, qui permettent de vérifier l'introduction des pieds 46 dans les trous 48. On remarque également que le tirant de transfert unique 24, décrit dans le mode de réalisation précédent, a été remplacé par une fourche 104 qui passe de part et d'autre de l'ascenseur 102.

Ce mode de réalisation présente l'avantage de permettre l'introduction de plusieurs plateaux porte-échantillon simultanément, ce qui réduit les manipulations lors de l'entrée et de la sortie de la boîte à gants. D'autre part, cela évite de rompre à plusieurs reprises le vide de la croix 76.

**Revendications**

1. Boîte étanche et amovible pour le transport d'échantillons conservés sous atmosphère contrôlée (70) d'une première enceinte étanche à une seconde enceinte étanche, caractérisée par :

-un corps étanche (2) délimitant une chambre (4) comportant une bride de raccordement (6) avec une ouverture - (5), qui est l'ouverture de la chambre (4) et pouvant s'appliquer contre une bride de raccordement de même type de ladite seconde enceinte ;

-un clapet (16) apte à obturer de manière étanche l'ouverture (5) de la chambre (4) ;

-des moyens (17, 19, 22, 24, 28, 30) pour commander l'ouverture et la fermeture du clapet (16) ;

-des moyens pour fixer un plateau porte-échantillon (38) sur une paroi (44) de la chambre (4) ;

-des moyens pour immobiliser le plateau porte-échantillon (38) lors du transport de la boîte.

2. Boîte de transport selon la revendication 1, dans laquelle le clapet (16) est monté pivotant sur le corps (2), un joint d'étanchéité (20) étant logé dans une gorge prévue dans le corps (2) autour de l'ouverture (5).

3. Boîte de transport selon la revendication 2, dans laquelle le clapet (16) est monté pivotant sur le corps (2) par l'intermédiaire d'un système de liaison constitué de deux pattes (18) solidaires du clapet (16), d'une pièce de liaison (17) montée pivotante sur les deux pattes (18), ladite pièce de liaison comportant une lumière (17a), le système comportant en outre une goupille (19) transversale à la pièce de liaison (17) et logée dans la lumière (17a).

4. Boîte de transport selon l'une quelconque des revendications 1 à 3, dans laquelle un tirant (22) relié à l'une de ses extrémités une bielle (24) articulée au centre du clapet (16) et, ledit tirant étant relié, à son autre extrémité, à une vis micrométrique faisant partie d'un système vis-écrou.

5. Boîte de transport selon l'une quelconque des revendications 1 à 4, dans laquelle les moyens pour fixer le porte-échantillon au corps (2) de la chambre (4) sont constitués par deux trous (46) espacés axialement, prévus dans une paroi (44) de la chambre (4), et par deux ergots (48) prévus sur un plateau porte-échantillon (38), les ergots - (48) étant aptes à venir se loger dans les deux trous (46).

6. Boîte de transport selon l'une quelconque des revendications 1 à 5, dans laquelle les moyens pour immobiliser le plateau porte-échantillon (38) lors du transport de la boîte sont constitués par la bielle (24) articulée au centre du clapet sur laquelle le porte-échantillon (42) s'appuie, la boîte de transport étant fermée.

7. Boîte de transport selon l'une quelconque des revendications 1 à 6, caractérisée en ce que le plateau porte-échantillon (38) comporte deux pieds (48) aptes à pénétrer dans les trous (46) de la boîte de transport, et un moyen de fixation (54) apte à coopérer avec un moyen complémentaire de transfert du plateau, le plateau (38) étant apte à recevoir un porte-échantillon (42).

8. Boîte de transport selon l'une quelconque des revendications 1 à 7, caractérisée en ce qu'elle comporte une canalisation (12) reliée à une bride (14) prévue pour raccorder la chambre (4) à une pompe à vide.

9. Boîte de transport selon l'une quelconque des revendications 1 à 8, caractérisée en ce qu'elle comporte un hublot (36) de visualisation permettant d'observer l'intérieur de la chambre (4).

10. Boîte de transport selon la revendication 9, caractérisée en ce que le hublot (36) est situé au niveau de la paroi (44) de la chambre (4).

11. Installation comportant une boîte de transport selon l'une quelconque des revendications 1 à 10, caractérisée en ce que ladite boîte de transport est accolée à ladite seconde enceinte étanche comportant une bride de raccord.

12. Installation selon la revendication 11, caractérisée en ce que ladite seconde enceinte étanche est une croix à plusieurs branches dont la branche sur laquelle est adaptée la boîte de transport a un diamètre qui permet l'ouverture du clapet (16) à 200° par rapport à l'axe de la chambre - (4).

13. Boîte de transport selon l'une quelconque des revendications 1 à 10, caractérisée en ce qu'elle comporte un ascenseur (102), une paroi de cet ascenseur comportant des moyens pour fixer une pluralité de plateaux porte-échantillon (38), ledit ascenseur étant mobile en translation par rapport au corps (2) de manière que chacun des plateaux porte-échantillon puisse être positionné en regard de l'ouverture (5) de la chambre (4).

0 196 252

FIG.1

66
76  75
81
52  1
82  74
77  80
124
120
122

FIG.9

66
90  76'  81  74'
52  1
80
96
92  80'  98
124
120

FIG. 2

# FIG.3

# FIG.4

FIG.5

FIG.6

FIG.7

FIG.8

0 196 252

FIG.10

0 196 252

FIG.11

0 196 252

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.⁴) |
|---|---|---|---|
| Y | US-A-3 858 049  (G.R. KOCH et al.)<br>* Abrégé; colonne 8, lignes 8-60; figures 1,14 * | 1,8 | H 01 J   37/20 |
| Y | US-A-4 227 080  (OKURA et al.)<br>* Colonne 4, lignes 4-23; revendication 1; figure 1 * | 1 | |
| A | JAPANESE JOURNAL OF APPLIED PHYSICS, vol. 21, no. 7, partie 2, juillet 1982, pages L429-L430, Tokyo, JP; O. NISHIKAWA et al.: "An airlock for a resistively heatable specimen of a field ion microscope and an atom-probe"<br>* En entier * | 1,2,9-12 | |
| A | PATENTS ABSTRACTS OF JAPAN, vol. 6, no. 132 (E-119) [1010], 17 juillet 1982, & JP - A - 57 59 329 (TOKYO SHIBAURA DENKI K.K.) 09-04-1982 | 1,13 | **DOMAINES TECHNIQUES RECHERCHES (Int. Cl.⁴)**<br><br>H 01 J   37/00<br>G 21 F    7/00 |
| A | US-A-4 301 371  (C. LIEB)<br>* Colonne 2, ligne 38 - colonne 3, ligne 37; figures * | 5-7 | |
| A | US-A-4 020 353  (SYOBU SAITO et al.) | | |

Le présent rapport de recherche a été établi pour toutes les revendications

| Lieu de la recherche | Date d'achèvement de la recherche | Examinateur |
|---|---|---|
| LA HAYE | 19-06-1986 | ERRANI C. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

OEB Form 1503 03 82